# EUROPEAN PATENT SPECIFICATION

(11) **EP 1 499 560 B1**
(45) Date of publication and mention of the grant of the patent: **14.12.2005**
(21) Application number: 02748681.0
(22) Date of filing: 29.04.2002
(51) Int. Cl.: B81B 7/00

(54) **DEVICE FOR PROTECTING A CHIP AND METHOD FOR OPERATING A CHIP**
VORRICHTUNG ZUM SCHUTZ EINES CHIPS UND VERFAHREN ZU DESSEN ANWENDUNG
DISPOSITIF DE PROTECTION D'UNE PUCE ET PROCEDE D'EXPLOITATION D'UNE PUCE

(43) Date of publication of application: 26.01.2005
(73) Proprietor: MICRONIC LASER SYSTEMS AB, 183 03 Täby (SE); Fraunhofer-Gesellschaft zur Förderung der angewandten Forschung e.V., 80686 München (DE)
(72) Inventor: Krellmann, Mathias, 01109 Dresden (DE); Karlin, Tord, Micronic Laser System A.B., 18303 Täby (SE)
(86) International application number: PCT/EP2002/004718
(87) International publication number: WO 2003/093167

(56) References cited:
- EP-A- 1 157 967
- WO-A-02/01633
- WO-A-99/37995
- PATENT ABSTRACTS OF JAPAN vol. 1997, no. 04, 30 April 1997 (1997-04-30) -& JP 08 327927 A (OMRON CORP), 13 December 1996 (1996-12-13)

## Description

The present invention relates to the protection of a chip from a degradation, and more specific to the protection of a chip from a degradation while being illuminated by a radiation.

Devices including micromirrors integrated on one or more chips are nowadays used in a variety of applications such as optical switching applications or light modulation applications. The micromirrors in the chips are mechanically displaced in response to an electrical signal, and light radiated from a light source and reflected by the micromirrors can be spatially modulated. For applications in the ultraviolet light region with wavelengths of about 248 nm, micromirrors formed of aluminum or aluminum alloys are used because of their good optical reflection properties in this region.

A known chip including micromirrors made of aluminum or an aluminum alloy has electrodes which are arranged subjacent to the micromirrors. To the electrodes, an electrical signal is applied for shifting the micromirrors. In a typical system the electrodes are covered with TiN for determining the end point in a CMP process (chemical mechanical polishing process) during a manufacturing of the chip.

However, when the electrodes covered with TiN have applied thereto a high potential and are in addition exposed to ultraviolet light, oxidation of the TiN is caused in an oxidating environment such as air. This occurs for example when a radiation is shining through slits which are formed between the mirrors and the mirror's hinges.

A problem resulting from the oxidation of the electrodes (TiO₂) is that the deflection of the micromirrors is reduced when the TiN is oxidized. The reasons for the reduction of the deflection of the micromirrors are not fully understood, however it is suspected that insulating charges are trapped in the oxide (TiO₂). The trapped charges cause a reduction of the electric field applied to deflect the mirrors and therefore the force acting on the mirror and causing the displacement is reduced. Thus, in order to obtain a stable operation, it is necessary to avoid the oxidization of the TiN material provided on the electrodes.

So far, the above described problem of oxidation of the TiN electrodes of the chip is not solved in a satisfying manner. Since it is commonly known that oxygen has a high share in the air one approach to resolve the problem is to avoid the contact of the TiN electrodes by enclosing the chip in an air tight box and evacuating the box.

The problem associated with this approach is that an air tight box is to provided which is only obtained by high precision manufacturing steps and high quality material rendering the manufacturing costly and difficult. Furthermore, by evacuating the box, forces caused by the surrounding air act on the box. Typically, a gas tight box is manufactured from one part of material using high standard working tools. In case multiple parts are used for forming the box some of same must be provided with high precision seals.

Furthermore, placing the chip in a box requires the provision of a window to allow a radiation to impinge on at least a portion of the chip, which in turn requires an air tight interface between the box and the window, e.g. in the form of seals placed around the circumference of the window. In addition to the costs for such seals, same are easily damaged for example during shipping and handling of the box.

Another problem with this approach is that an increased amount of maintenance is necessary since the air tight box has to be checked regularly for possible leaks since even a small leak causes air to flow into the box. Such measurements might require additional equipment such as pressure sensors in the box. This results in additional efforts and costs.

Another approach for protecting the chip from oxidation is to place the chip in a box and to fill the box with a protective gas at a pressure higher than the air pressure. However, in this case the box also has to be air tight to prevent the protective gas from rapidly escaping to the exterior of the box and to prevent surrounding air from penetrating into the interior of the box and mixing with the protective gas. Thus, the same problem as outlined above apply for this approach.

WO 02/01633 A describes a miniature microdevice package comprising a frame substrate and a microdevice guide forming a chamber for receiving a microdevice integrated on the microdevice substrate. A window is arranged opposite to the microdevice for allowing radiation inside the chamber. A pump-out channel is provided in the substrate allowing the chamber to be pumped-out of air during the manufacturing process in order to provide a vacuum inside the chamber after the pump-out channel is sealed in order to obtain an hermetically-sealed chamber.

Starting from this prior art, it is the object of the present invention to provide an improved device and an improved method for protecting a chip from a degradation for enabling a stable operation of a chip.

This object is solved by a device according to claim 1 and a method according to claim 10.

The present invention provides a device for protecting a chip as specified in claim 1.

Furthermore, the present invention provides a method for operating a device for protecting a chip as specified in claim 10.

According to one preferred embodiment, the chip comprises micromirrors made of aluminum or an aluminum alloy and electrodes which are covered with layers made of TiN material and arranged on the chip subjacent to the electrodes for applying electrostatic forces to the micromirrors. An oxidation of the TiN material is avoided by purging the air from the chip by means of a gas flow while the chip is illuminated at least to a part by UV-radiation and is operated by deflecting the micromirrors in response to electrical signals applied to the electrodes.

Preferred embodiments of the present invention are described in the following with respect to the attached drawings in which
Fig. 1 shows a top view of a preferred embodiment of the present invention; and
Fig. 2 shows a side view of the embodiment of Fig. 1.

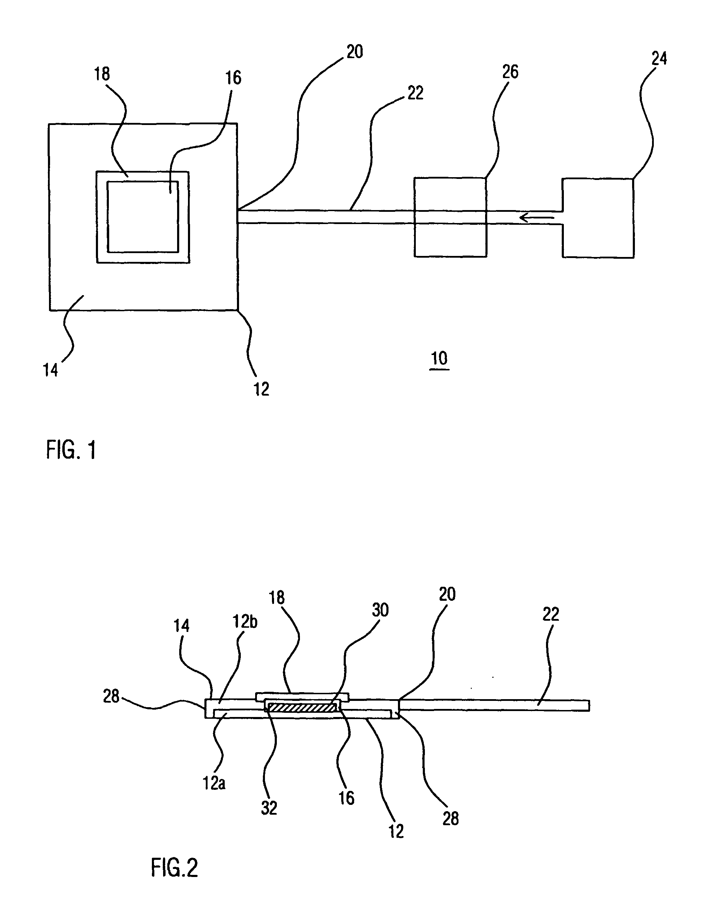

In Fig. 1 a device 10 according to a preferred embodiment of the present application is shown. The device 10 is for protecting a chip from a degradation and comprises a housing 12, also referred to as box. The present invention is not restricted to a certain form of the housing 12 and besides the form shown in the figures other forms such as a cylindrical form are also intended for use in the present invention.

The housing 12 has an upper surface 14 in which a recess 16 is formed. The recess 16 is adapted to receive the chip. Preferably, the recess 16 has the dimensions somewhat larger than the dimensions of the chip such that only a small distance between the chip and sidewalls of the recess 16 remains when the chip is arranged in the recess 16. This allows a gas flow to be directed along a surface of the chip as will be explained in further detail below.

Further, an optical window 18 is arranged on the upper side of the housing 12 to allow an UV radiation to pass through the optical window 18 and to impinge on at least a portion of the surface of the chip placed in the recess 16. The window 18 extends over and beyond the recess 16 such that the entire surface of the chip opposing the window 18 can be illuminated with a UV radiation. The optical window is formed of a quartz material or any other material which lets UV pass, e.g. MgF₂.

The device 10 includes a gas inlet 20 at the housing 12. The gas inlet 20 is adapted to receive a tube 22. The gas inlet 20 is in communication with the recess 16 to allow gas to flow from the tube 22 into the recess 16 of the housing 12. Although the gas inlet 20 is arranged at a side of the housing 12 same could be arranged at a lower surface of the housing 12 opposing the upper surface 14 or at any other suitable position.

The gas tube 22 is connected at its other end to a gas supply 24 holding a protective gas. A gas flow from the gas supply 24 to the recess 16 of the housing 12 is controlled by a mass flow controller 26.

Preferably, the protective gas is either argon or nitrogen/hydrogen. However, other gases known to provide for protection against oxidation can be used in other embodiments.

The mass flow controller 26 can be of the commonly available type and is operable to control the flow rate of the gas according to predetermined parameters such as the volume of the recess 16 of the housing 12.

In Fig. 2, a cross-sectional view of the housing 12 and the tube 20 of Fig. 1 is shown. The housing 12 is formed of a chip housing 12a which serves as a base plate and a top plate 12b having at a periphery thereof flanges portion 28 extending downward. The chip housing 12a is reversibly attached to the top plate 12b. The recess 16 is formed in the top plate 12b and extends completely therethrough. The window 18 is formed on the upper surface 14 of the top plate 12b. A chip 30 is placed on the chip housing 12a as is shown in Fig. 2 such that same is placed in the recess 16 when the chip housing 12a and the top plate 12b are combined. As can be seen, the chip 30 and the recess 16 are determined such that a gap 32 between the chip, the side walls of the recess 16 and the window 18 is maintained, allowing a gas to pass the chip 30. Since no gas tight seal is required, replacement of the chip 30 is easy.

In the following, the operation of the device 10 will be described in further detail with respect to a further embodiment using a specific chip 30. The chip 30 comprises a micromirror made of aluminum or an aluminum alloy. An electrode is arranged subjacent to the micromirror for applying an electrostatic force on the micromirror in response to an electrical signal applied to the electrode. The electrode is covered with TiN for determining the end point in a CMP process (chemical mechanical polishing process) during a manufacturing of the chip.

In operation, the chip 30 is placed in the chamber formed by the recess 16, the window 18 and the chip housing 12a to prevent the oxidation of the TiN material covering the electrodes. A protective gas from the gas supply 24 is applied under the control of the mass flow controller 26 through tube 22 and the gas inlet 20 into the interior of the chamber.

After flowing from the gas inlet 20 into the chamber, the gas flows along the gap 32 to the chip 30 to pass an upper surface of the chip 30 opposed to window 18. By means of the gas flow passing the chip 30, air is purged from the chip 30. The chamber is not provided air tight and the gas together with the air purged by the gas flow is allowed to leave the chamber. To establish the gas flow over the entire upper surface of the chip 30, the housing 12 is preferably designed to enable the gas to leave the chamber at the side of the chamber opposed to the gas inlet 20. Additional means to allow the gas to escape from the chamber can be provided in the flange 28 opposed to the gas inlet 20.

A gas outlet is provided opposed to the gas inlet 20. Thus, gas flowing out of the chamber can be redirected to the gas supply in order to achieve a closed gas circuit. This is useful when an expensive protective gas is used in order to minimize losses of protective gas.

Due to the gas flowing through the chamber, the air from the chamber is removed and the chamber is kept thereafter free from air as long as the gas flow is maintained in the chamber.

Moreover, the gas flow provides a cooling for the chip 30 which is heated by the radiation impinging on same as will be described below.

During an operation of the chip 30, UV radiation generated by a suitable source such as a Hg-lamp or a laser is directed to the window 18 and passes window 18 to impinge on the micromirror arranged on the upper surface of the chip 30 opposed to the window 18. The window 18 is made of quartz, MgF₂ or any other material transparent for UV radiation to allow a high ratio of the UV-light to pass through the window 18 and to impinge on the chip 30. Preferably, the window 18 is tilted with respect to the upper surface of the chip 30 to avoid double imaging.

The UV radiation impinging on the micromirror is reflected by same and directed to the exterior of housing 12 after passing window 18. Electric signals are applied to the electrodes provided subjacent to the micromirror on the upper surface of the chip 30. The electric signals which are generated from a power supply outside of the chamber are applied to the electrodes via means for electrical connection.

In response to the electric signals, electrostatic forces are acting on the micromirror causing the micromirror to shift. The shifting of the micromirror causes a change of the direction of the reflected beam. Thus, in response to the electrical signals applied to the electrodes, a spatial modulation of the reflected beam is obtained at the location where the reflected beam is impinging.

Since the chamber is maintained free from air, O₂ and moisture, a non-oxidizing surrounding is established for the chip 30 placed in the chamber. This prevents an oxidation of the TiN material covering the electrodes subjacent to the micromirror during the operation of the chip 30 which would otherwise take place if the chip 30 would be subjected to an oxidizing reactant such as the oxygen contained in the air. As described above, an oxidation of the TiN material during the operation of the chip 30 in an oxidizing atmosphere takes place when a high electric potential is applied to the electrode and an UV radiation shining through slits provided between the micromirror and a hinge of the micromirror impinges on the TiN material. In case the oxidation of the TiN material is not prevented, the shifting of the micromirror in response to the electric signal applied to the electrode is reduced causing an unstable operation of the chip.

Preferably, the recess 16 is designed to provide the gap 32 between the chip 30 and the optical window 18 with a small cross-section. This enables that the gas flow has a high flow rate along the surface of chip 30 impinged by radiation through optical window 18. Thus, with the small gap 32 provided, air is purged from the chip 30 with a high rate in the regions where the protection is required, i.e. in the regions impinged by the radiation. Furthermore, the small gap 32 allows a high protection even in the case when the gas flow from the gas supply 24 to the gas inlet is set to a low level by the mass flow controller 26.

With the inventive solution of providing a gas flow through the chamber, an inexpensive protection for the chip 30 is obtained since the chamber is not required to be air tight rendering the manufacturing of the housing 12 cheap.

Furthermore, the technical equipment such as the gas supply 22 or the mass flow controller 24 can be of the commonly available type providing in addition to the low costs an easy handling of same.

In addition, the costs for maintenance are low since regular checks for leakage are not necessary for a stable operation. In case a leakage might occur, mass flow controller 24 can be provided to detect an increasing gas flow indicating a possible leakage. In such a case the mass flow controller is operable to provide a higher gas pressure to prevent air from penetrating into the chamber.

The inventive device 10 can further be integrated in existing systems which use a chip similar to the chip 30 for modulation of radiation. Such an integration is easy to achieve since no special technology is required.

Furthermore, the size and design of recess 16 can be chosen according to the demands of the chip 30. In one embodiment it is intended to place the chip 30 together with its package into the recess 16. In this embodiment, the recess 16 is adapted to receive the chip 30 with its package and the chip 30 is kept free from air by means of the gas flow provided in the chamber along the surface of the package and purging air from the chip.

Although preferred embodiments have been described in which the chip 30 comprises a micromirror made of aluminum or an aluminum alloy and further comprises an electrode covered with TiN the present invention is not restricted to this particular chip 30.

To give an example, it is intended in one embodiment to use a chip 30 which comprises a plurality of micromirrors and a plurality of electrodes covered with TiN.

Furthermore, although preferred embodiments have been described in which the chip 30 is prevented against oxidation of TiN during the illumination of the chip 30 with UV radiation, the present invention is not restricted to this particular protection.

Rather the present invention is intended to provide a general protection for the chip 30 against influences caused due to the presence of reaction components during the illumination of the chip 30 with a radiation.

## Claims

1. Device (10) for protecting a chip (30) including at least one micromirror being displaceable in response to an applied signal, from a degradation due to a reaction of a portion of the chip with reaction components while being illuminated by a radiation, the device (10) comprising
a chamber (16) adapted to receive the chip (30) ; and
a window (18) allowing the radiation to pass therethrough and to impinge at least on a portion of the chip (30);
wherein the device (10) comprises
a gas inlet (20) in communication with the chamber (16), the gas inlet (20) being adapted to receive from a gas supply (24) a gas flow, and in addition to the gas inlet, a gas outlet in communication with the chamber (16), the gas outlet being adapted to receive gas from the chamber (16).

2. Device (10) according to claim 1, wherein the reaction component is the oxygen contained in the ambient air, and wherein the gas flow provides a protection against oxidation of oxidizable parts of the chip (30) during operation of the chip (30) due to the radiation impinging on the chip (30).

3. Device (10) according to claim 1 or 2, wherein the chamber (16) allows gas to leak to an ambient atmosphere.

4. Device (10) according to any one of claims 1 to 3, wherein the window (18) is tilted with respect to a surface of the chip (30).

5. Device (10) according to any one of claims 1 to 4, wherein the window is adapted to transmit UV radiation.

6. Device (10) according to claim 5, wherein the window (18) is transparent to the UV radiation, the chip (30) comprising a micromirror containing aluminum or an aluminum alloy and an electrode for generating an electric force between the micromirror and the electrode for displacing the micromirror, the electrode formed of or containing TiN, the chip being mounted in a package.

7. Device (10) according to any one of claims 1 to 6, wherein the chamber (16) comprises means for an electrical connection of the chip (30) to a power supply outside the chamber (16).

8. Device (10) according to any one of claims 1 to 7, further comprising a housing (12, 12a, 12b) wherein the chamber (16) is formed by a recess in the housing (12, 12a, 12b).

9. Device (10) according to any one of claims 1 to 8, further comprising a housing including a chip housing (12a) and a top (12b) plate.

10. Method for operating a device according to any one of claims 1 to 9, , the method comprising the following steps:
applying a gas flow to the chip (30) through the gas inlet (20) and the gas outlet of the chamber (16); and
illuminating the chip (30) while the gas flow is applied to the chip (30).

11. Method according to claim 10, wherein the radiation is an UV radiation.

12. Method according to claim 10 or 11, wherein the electrodes are formed of TiN, and the gas flow prevents an oxidation of the electrodes during an operation of the chip (30) due to radiation impinging on the chip (30).

## Patentansprüche

1. Vorrichtung (10) zum Schutz eines mit einer Strahlung bestrahlten Chips (30) vor einem Abbau durch eine Reaktion eines Teils des Chips mit Reaktionskomponenten, mit
mindestens einem Mikrospiegel, welcher ansprechend auf ein angelegtes Signal verschiebbar ist;
einer Kammer (16), welche zur Aufnahme des Chips (30) ausgelegt ist; und
einem Fenster (18), welches die Strahlung durchläßt und auf mindestens einen Teil des Chips (30) auftreffen läßt;
wobei die Vorrichtung (10)
einen Gaseinlass (20) umfasst, der mit der Kammer (16) kommuniziert und dazu ausgelegt ist, eine Gasströmung aus einer Gasversorgung (24) aufzunehmen; und zusätzlich zum Gaseinlass
einen Gasauslass umfasst, der mit der Kammer (16) kommuniziert und dazu ausgelegt ist, Gas aus der Kammer (16) aufzunehmen.

2. Vorrichtung (10) nach Anspruch 1, bei welcher die Reaktionskomponente aus dem in der umgebenden Luft befindlichen Sauerstoff besteht, und bei welcher die Gasströmung während des Betriebs des Chips (30) einen Schutz gegen eine Oxidation von oxidierbaren Teilen des Chips (30) aufgrund der auf den Chip (30) auftreffenden Strahlung vorsieht.

3. Vorrichtung (10) nach Anspruch 1 oder 2, bei welcher die Kammer (16) ein Entweichen von Gas in die umgebende Atmosphäre gestattet.

4. Vorrichtung (10) nach einem der Ansprüche 1 bis 3, bei welcher das Fenster (18) gegenüber einer Oberfläche des Chips (30) gekippt ist.

5. Vorrichtung (10) nach einem der Ansprüche 1 bis 4, bei welcher das Fenster zur Transmission von UV-Strahlung ausgelegt ist.

6. Vorrichtung (10) nach Anspruch 5, bei welcher das Fenster (18) für die UV-Strahlung durchlässig ist, der Chip (30) einen Mikrospiegel, welcher Aluminium oder eine Aluminiumlegierung enthält, und zum Verschieben des Mikrospiegels eine Elektrode zum Erzeugen einer elektrischen Kraft zwischen dem Mikrospiegel und der Elektrode aufweist, die Elektrode aus TiN geformt ist oder dieses enthält und der Chip auf einer Platte montiert ist.

7. Vorrichtung (10) nach einem der Ansprüche 1 bis 6, bei welcher die Kammer (16) Mittel zum elektrischen verbinden des Chips (30) mit einer außerhalb der Kammer (16) befindlichen Stromversorgung umfasst.

8. Vorrichtung (10) nach einem der Ansprüche 1 bis 7, welche zusätzlich ein Gehäuse (12, 12a, 12b) umfasst, wobei die Kammer (16) von einer Ausnehmung in dem Gehäuse (12, 12a, 12b) gebildet wird.

9. Vorrichtung (10) nach einem der Ansprüche 1 bis 8, welche zusätzlich ein Gehäuse aufweist, welches ein Chipgehäuse (12a) und eine Deckplatte (12b) umfasst.

10. Verfahren zum Betreiben einer Vorrichtung nach einem der Ansprüche 1 bis 9, wobei das Verfahren die folgenden Schritte umfasst:
Beaufschlagen des Chips (30) mit einer über den Gaseinlass (20) und den Gasauslass der Kammer (16) fließenden Gasströmung; und
Bestrahlen des Chips (30) während der Chip (30) der Gasströmung ausgesetzt ist.

11. Verfahren nach Anspruch 10, bei dem die Strahlung eine W-Strahlung ist.

12. Verfahren nach Anspruch 10 oder 11, bei dem die Elektroden aus TiN gebildet sind, und die Gasströmung während eines Betriebs des Chips (30) eine Oxidation der Elektroden infolge einer auf den Chip (30) auftreffenden Strahlung verhindert.

## Revendications

1. Dispositif (10) de protection d'une puce (30), incorporant au moins un micro-miroir qui est déplaçable en réponse à un signal appliqué, d'une dégradation due à une réaction d'une partie de la puce avec des composants réactionnels pendant qu'elle est éclairée par un rayonnement, le dispositif (10) comprenant
une chambre (16) adaptée à recevoir la puce (30); et
une fenêtre (18) permettant au rayonnement de passer à travers elle et de tomber au moins sur une partie de la puce (30);
où le dispositif (10) comprend
une entrée de gaz (20) en communication avec la chambre (16), l'entrée de gaz (20) étant adaptée à recevoir un écoulement de gaz à partir d'une amenée de gaz (24) et, en plus de l'entrée de gaz, une sortie de gaz en communication avec la chambre (16), la sortie de gaz étant adaptée à recevoir du gaz en provenance de la chambre (16).

2. Dispositif (10) selon la revendication 1, dans lequel le composant réactionnel est l'oxygène contenu dans l'air ambiant, et dans lequel l'écoulement de gaz fournit une protection contre l'oxydation de parties oxydables de la puce (30) pendant le fonctionnement de la puce (30) du fait du rayonnement tombant sur la puce (30).

3. Dispositif (10) selon la revendication 1 ou 2, dans lequel la chambre (16) permet à du gaz de fuir vers l'atmosphère ambiante.

4. Dispositif (10) selon l'une quelconque des revendications 1 à 3, dans lequel la fenêtre (18) est inclinée par rapport à une surface de la puce (30).

5. Dispositif (10) selon l'une quelconque des revendications 1 à 4, dans lequel la fenêtre est adaptée à transmettre un rayonnement UV.

6. Dispositif (10) selon la revendication 5, dans lequel la fenêtre (18) est transparente au rayonnement UV, la puce (30) comprenant un micro-miroir contenant de l'aluminium ou un alliage d'aluminium et une électrode pour produire une force électrique entre le micro-miroir et l'électrode permettant de déplacer le micro-miroir, l'électrode étant formée de TiN ou en contenant, la puce étant montée dans un ensemble.

7. Dispositif (10) selon l'une quelconque des revendications 1 à 6, dans lequel la chambre (16) comprend des moyens pour une liaison électrique de la puce (30) à une alimentation électrique à l'extérieur de la chambre (16).

8. Dispositif (10) selon l'une quelconque des revendications 1 à 7, comprenant en outre un boîtier (12, 12a, 12b) dans lequel la chambre (16) est formée par un évidement dans le boîtier (12, 12a, 12b).

9. Dispositif (10) selon l'une quelconque des revendications 1 à 8, comprenant en outre un boîtier incluant un boîtier de puce (12a) et une plaque de dessus (12b).

10. Procédé pour faire fonctionner un dispositif selon l'une quelconque des revendications 1 à 9, le procédé comprenant les étapes suivantes consistant à:
appliquer un écoulement de gaz à la puce (30) par l'intermédiaire de l'entrée de gaz (20) et de la sortie de gaz de la chambre (16); et
éclairer la puce (30) pendant que l'écoulement de gaz est appliqué à la puce (30).

11. Procédé selon la revendication 10, dans lequel le rayonnement est un rayonnement UV.

12. Procédé selon la revendication 10 ou 11, dans lequel les électrodes sont formées de TiN, et dans lequel l'écoulement de gaz empêche une oxydation des électrodes pendant le fonctionnement de la puce (30) du fait d'un rayonnement tombant sur la puce (30).
